# EUROPEAN PATENT SPECIFICATION

(11) **EP 4 123 876 B1**
(45) Date of publication and mention of the grant of the patent: **07.05.2025**
(21) Application number: 20926228.6
(22) Date of filing: 21.12.2020
(51) Int. Cl.: H02J 50/30, H02J 50/80, H04J 14/02, H04B 10/80

(54) **OPTICAL POWER FEED SYSTEM**
OPTISCHES STROMVERSORGUNGSSYSTEM
SYSTÈME D'ALIMENTATION ÉLECTRIQUE OPTIQUE

(30) Priority: 16.03.2020 JP 2020044889
(43) Date of publication of application: 25.01.2023
(73) Proprietor: Kyocera Corporation, Kyoto-shi, Kyoto 612-8501 (JP)
(72) Inventor: SUGIME, Tomonori, Kyoto-shi, Kyoto 612-8501 (JP)
(74) Representative: Viering, Jentschura & Partner mbB Patent- und Rechtsanwälte
(86) International application number: PCT/JP2020/047609
(87) International publication number: WO 2021/186828

(56) References cited:
- WO-A1-2011/158283
- CN-A- 104 768 454
- CN-A- 105 978 445
- CN-A- 108 900 141
- JP-A- 2005 198 396
- JP-A- 2005 198 396
- JP-A- 2015 001 925

## Description

### Technical Field

The present disclosure relates to optical power supply.

### Background Art

Recently, an optical power supply system has been studied that converts electric power into light (called feed light), transmits the feed light, converts the feed light into electric energy, and uses the electric energy as electric power.

PTL 1 discloses an optical communication device including an optical transmitter, an optical fiber, and an optical receiver. The optical transmitter transmits signal light modulated based on an electric signal and feed light for supplying electric power. The optical fiber includes a core, a first cladding surrounding the core, and a second cladding surrounding the first cladding. The core transmits the signal light. The first cladding has a refractive index lower than that of the core and transmits the feed light. The second cladding has a refractive index lower than that of the first cladding. The optical receiver operates with electric power obtained by converting the feed light transmitted through the first cladding of the optical fiber and converts the signal light transmitted through the core of the optical fiber into the electric signal.

### Citation List

### Patent Literature

PTL 1: Japanese Unexamined Patent Application Publication No. 2010-135989

CN 105 978 445 A discloses an optical fiber energy supply system based on a multi-junction concentrating photovoltaic battery comprising a laser module, an optical fiber coupling module, a light splitting module, and photovoltaic conversion modules, wherein the laser module uses a multiband laser module and laser beams output by the multiband laser module are incident to an energy transmission optical fiber after being merged through the optical fiber coupling module.

JP 2005 198396 A discloses an optical power supply system wherein energy is transmitted from a center station including a plurality of different light sources.

WO 2011/158283 A1 discloses an optical transmission system, wherein electrical power from a parent device is transmitted to a child device via an optical transmission line, the parent device comprising an optical amplifier for amplifying main signal light and electrical power supplying light.

### Summary of Invention

### Technical Problem

If a spectrum of feed light spreads beyond a conversion wavelength range of a photoelectric conversion element, the feed light outside the conversion wavelength range is not converted into electric power. Consequently, the power supply efficiency problematically decreases.

### Solution to Problem

The present invention provides an optical power supply system according to claim 1. Preferred embodiments are described in the dependent claims.

### Advantageous Effects of Invention

In the one aspect of the present disclosure, the powered device of the optical power supply system can perform photoelectric conversion on the feed light without the feed light becoming out of the conversion wavelength ranges of the photoelectric conversion elements and thus can maintain a high power supply efficiency.

### Brief Description of Drawings

[Fig. 1] Fig. 1 is a diagram illustrating a configuration of a power-over-fiber system according to a first embodiment of the present disclosure.
[Fig. 2] Fig. 2 is a diagram illustrating a configuration of a power-over-fiber system according to a second embodiment of the present disclosure.
[Fig. 3] Fig. 3 is a diagram illustrating the configuration of the power-over-fiber system according to the second embodiment of the present disclosure, and illustrates optical connectors, etc.
[Fig. 4] Fig. 4 is a diagram illustrating a configuration of a power-over-fiber system according to another embodiment of the present disclosure.
[Fig. 5] Fig. 5 is a diagram illustrating a configuration of a power-over-fiber system including a beam splitter and three photoelectric conversion elements having different conversion wavelength ranges, along with an explanatory diagram illustrating a spectrum of wide-band feed light.
[Fig. 6] Fig. 6 is a diagram illustrating a configuration of a power-over-fiber system including one photoelectric conversion element, along with an explanatory diagram illustrating a spectrum of narrow-band feed light.
[Fig. 7] Fig. 7 is a diagram illustrating a configuration of a power-over-fiber system including one photoelectric conversion element, along with an explanatory diagram illustrating a spectrum of wide-band feed light. Description of Embodiments

One embodiment of the present disclosure is described below with reference to the drawings.

### (1) Overview of System

### [First Embodiment of the disclosure]

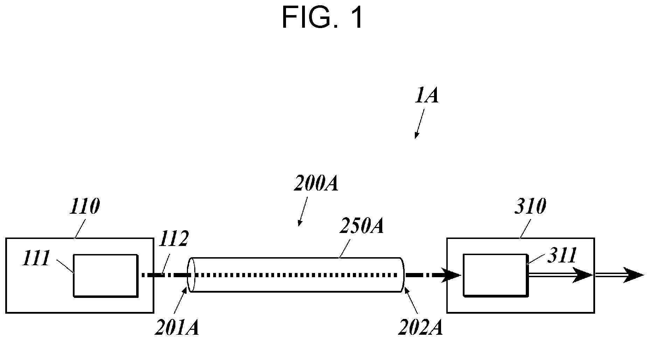

As illustrated in Fig. 1, a power-over-fiber (PoF) system 1A according to the present embodiment includes power sourcing equipment (PSE) 110, an optical fiber cable 200A, and a powered device (PD) 310.

In the present disclosure, the power sourcing equipment 110 is equipment that converts electric power into optical energy and supplies the optical energy, and the powered device 310 is a device that receives the supplied optical energy and converts the optical energy into electric power.

The power sourcing equipment 110 includes a semiconductor laser 111 for power supply.

The optical fiber cable 200A includes an optical fiber 250A that forms a channel of feed light.

The powered device 310 includes a photoelectric conversion element 311.

The power sourcing equipment 110 is connected to a power source, which electrically drives the semiconductor laser 111 for power supply and so on.

The semiconductor laser 111 for power supply oscillates with electric power supplied from the power source to output feed light 112.

The optical fiber cable 200A has one end 201A connectable to the power sourcing equipment 110 and an other end 202A connectable to the powered device 310, and transmits the feed light 112.

The feed light 112 from the power sourcing equipment 110 is input to the one end 201A of the optical fiber cable 200A. The feed light 112 propagates through the optical fiber 250A and is output from the other end 202A to the powered device 310.

The photoelectric conversion element 311 converts the feed light 112 transmitted through the optical fiber cable 200A into electric power. The electric power obtained by the photoelectric conversion element 311 through the conversion is used as driving electric power needed in the powered device 310. The powered device 310 is capable of outputting, for an external device, the electric power obtained by the photoelectric conversion element 311 through the conversion.

Semiconductor materials comprise semiconductor regions that exhibit a photoelectric effect of the semiconductor laser 111 for power supply and the photoelectric conversion element 311 are semiconductors having a short laser wavelength of 500 nm or shorter.

Semiconductors having a short laser wavelength have a large band gap and a high photoelectric conversion efficiency. Thus, the photoelectric conversion efficiency on the power-generating side and the powered side of optical power supply improves, and consequently the optical power supply efficiency improves.

Therefore, the semiconductor materials to be used may be, for example, semiconductor materials that are laser media having a laser wavelength (fundamental wave) of 200 to 500 nm such as diamond, gallium oxide, aluminum nitride, and gallium nitride.

The semiconductor materials to be used may be semiconductors having a band gap of 2.4 eV or greater.

For example, semiconductor materials that are laser media having a band gap of 2.4 to 6.2 eV such as diamond, gallium oxide, aluminum nitride, and gallium nitride may be used.

Laser light having a longer wavelength tends to have a higher transmission efficiency. Laser light having a shorter wavelength tends to have a higher photoelectric conversion efficiency. Thus, in the case of long-distance transmission, a semiconductor material that is a laser medium having a laser wavelength (fundamental wave) longer than 500 nm may be used. When the photoelectric conversion efficiency is prioritized, a semiconductor material that is a laser medium having a laser wavelength (fundamental wave) shorter than 200 nm may be used.

These semiconductor materials may be used in either the semiconductor laser 111 for power supply or the photoelectric conversion element 311. The photoelectric conversion efficiency is improved on the power-sourcing side or the powered side, and consequently the optical power supply efficiency improves.

### [Second Embodiment of the disclosure]

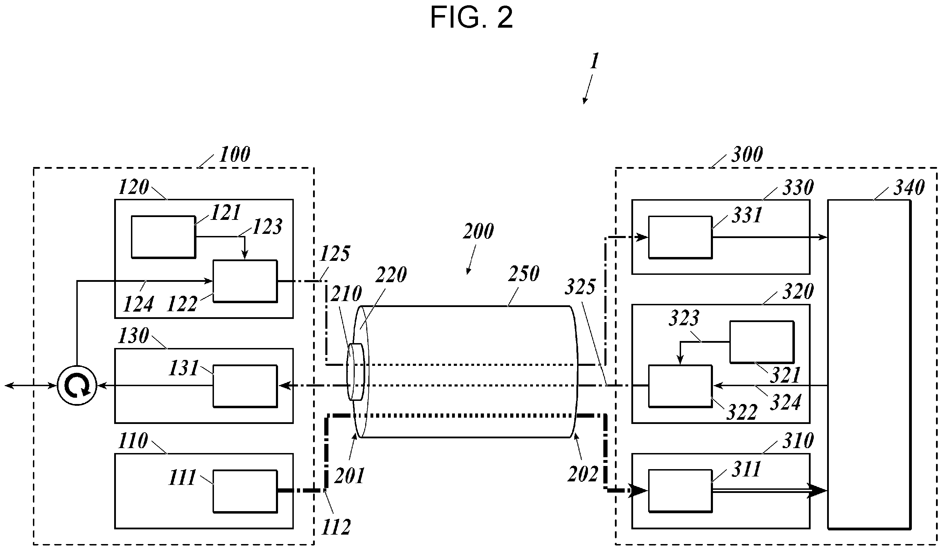

As illustrated in Fig. 2, a power-over-fiber (PoF) system 1 according to the present embodiment is a system including a power supply system and an optical communication system with an optical fiber. Specifically, the power-over-fiber system 1 includes a first data communication device 100 including power sourcing equipment (PSE) 110, an optical fiber cable 200, and a second data communication device 300 including a powered device (PD) 310.

The power sourcing equipment 110 includes a semiconductor laser 111 for power supply. The first data communication device 100 includes, in addition to the power sourcing equipment 110, a transmitter 120 and a receiver 130 that perform data communication. The first data communication device 100 corresponds to data terminal equipment (DTE), a repeater, or the like. The transmitter 120 includes a semiconductor laser 121 for signals and a modulator 122. The receiver 130 includes a photodiode 131 for signals.

The optical fiber cable 200 includes an optical fiber 250 including a core 210 and a cladding 220. The core 210 forms a channel of signal light. The cladding 220 is arranged to surround the core 210 and forms a channel of feed light.

The powered device 310 includes a photoelectric conversion element 311. The second data communication device 300 includes, in addition to the powered device 310, a transmitter 320, a receiver 330, and a data processor 340. The second data communication device 300 corresponds to a power end station or the like. The transmitter 320 includes a semiconductor laser 321 for signals and a modulator 322. The receiver 330 includes a photodiode 331 for signals. The data processor 340 is a unit that processes a received signal. The second data communication device 300 is a node in a communication network. Alternatively, the second data communication device 300 may be a node that communicates with another node.

The first data communication device 100 is connected to a power source, which electrically drives the semiconductor laser 111 for power supply, the semiconductor laser 121 for signals, the modulator 122, the photodiode 131 for signals, and so on. The first data communication device 100 is a node in the communication network. Alternatively, the first data communication device 100 may be a node that communicates with another node.

The semiconductor laser 111 for power supply oscillates with electric power supplied from the power source to output feed light 112.

The photoelectric conversion element 311 converts the feed light 112 transmitted through the optical fiber cable 200 into electric power. The electric power obtained by the photoelectric conversion element 311 through the conversion is used as driving electric power for the transmitter 320, the receiver 330, and the data processor 340 and as other driving electric power needed in the second data communication device 300. The second data communication device 300 may be capable of outputting, for an external device, the electric power obtained by the photoelectric conversion element 311 through the conversion.

On the other hand, the modulator 122 of the transmitter 120 modulates laser light 123 output from the semiconductor laser 121 for signals into signal light 125 on the basis of transmission data 124, and outputs the signal light 125.

The photodiode 331 for signals of the receiver 330 demodulates the signal light 125 transmitted through the optical fiber cable 200 into an electric signal, and outputs the electric signal to the data processor 340. The data processor 340 transmits data based on the electric signal to a node. The data processor 340 also receives data from the node, and outputs, as transmission data 324, the data to the modulator 322.

The modulator 322 of the transmitter 320 modulates laser light 323 output from the semiconductor laser 321 for signals into signal light 325 on the basis of the transmission data 324, and outputs the signal light 325.

The photodiode 131 for signals of the receiver 130 demodulates the signal light 325 transmitted through the optical fiber cable 200 into an electric signal, and outputs the electric signal. Data based on the electric signal is transmitted to a node. On the other hand, data from the node is treated as the transmission data 124.

The feed light 112 and the signal light 125 output from the first data communication device 100 are input to one end 201 of the optical fiber cable 200. The feed light 112 and the signal light 125 propagate through the cladding 220 and the core 210, respectively, and are output from an other end 202 of the optical fiber cable 200 to the second data communication device 300.

The signal light 325 output from the second data communication device 300 is input to the other end 202 of the optical fiber cable 200, propagates through the core 210, and is output from the one end 201 of the optical fiber cable 200 to the first data communication device 100.

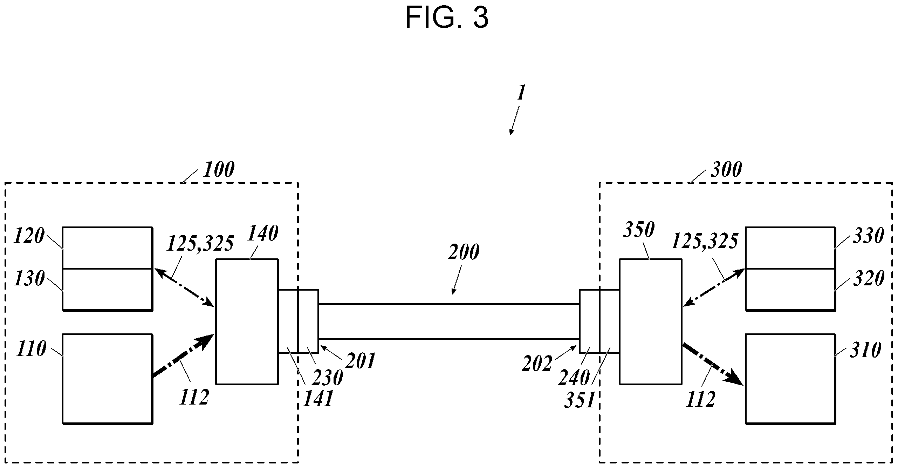

As illustrated in Fig. 3, the first data communication device 100 includes a light input/output part 140 and an optical connector 141 attached to the light input/output part 140. The second data communication device 300 includes a light input/output part 350 and an optical connector 351 attached to the light input/output part 350. An optical connector 230 at the one end 201 of the optical fiber cable 200 is connected to the optical connector 141. An optical connector 240 at the other end 202 of the optical fiber cable 200 is connected to the optical connector 351. The light input/output part 140 guides the feed light 112 to the cladding 220, guides the signal light 125 to the core 210, and guides the signal light 325 to the receiver 130. The light input/output part 350 guides the feed light 112 to the powered device 310, guides the signal light 125 to the receiver 330, and guides the signal light 325 to the core 210.

As described above, the optical fiber cable 200 has the one end 201 connectable to the first data communication device 100 and the other end 202 connectable to the second data communication device 300, and transmits the feed light 112. In the present embodiment, the optical fiber cable 200 transmits the signal light 125 and the signal light 325 bidirectionally.

As semiconductor materials of semiconductor regions that exhibit a photoelectric effect of the semiconductor laser 111 for power supply and the photoelectric conversion element 311, same and/or similar materials as those mentioned in the first embodiment may be used, so that a high optical power supply efficiency is implemented.

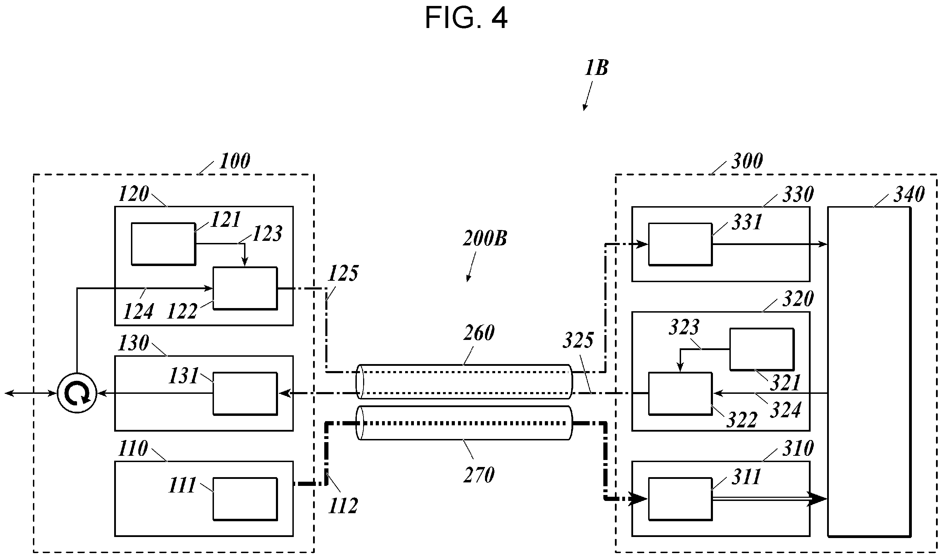

As in an optical fiber cable 200B of a power-over-fiber system 1B illustrated in Fig. 4, an optical fiber 260 that transmits signal light and an optical fiber 270 that transmits feed light may be provided separately. The optical fiber cable 200B may include a plurality of optical fiber cables.

### (2) Wavelength-Division Photoelectric Conversion of Wide-Band Feed Light

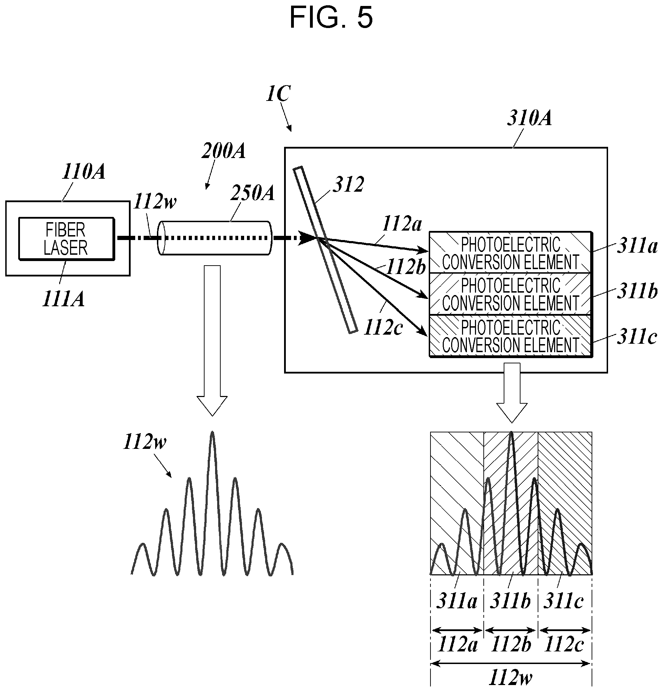

Power sourcing equipment 110A illustrated in Fig. 5 is used instead of the power sourcing equipment 110 of the power-over-fiber systems 1A, 1, and 1B described above, and a powered device 310A illustrated in Fig. 5 is used instead of the powered device 310 of the power-over-fiber systems 1A, 1, and 1B described above.

Fig. 5 is based on Fig. 1 and also illustrates a spectrum of feed light. Fig. 5 illustrates a power-over-fiber system 1C according to the present invention.

The power sourcing equipment 110A includes a fiber laser 111A as a laser light source. The fiber laser 111A can achieve high output and thus is suitable for optical power supply of large electric power. However, feed light 112W output by the fiber laser 111A has a spread spectrum as illustrated in Fig. 5.

The powered device 310A includes a plurality of photoelectric conversion elements 311a, 311b, and 311c. In this example, three photoelectric conversion elements are used.

The powered device 310A also includes a beam splitter 312.

The beam splitter 312 receives the wide-band feed light 112W output from the fiber laser 111A and transmitted through the optical fiber 250.

The beam splitter 312 splits the feed light 112W into a plurality of feed light and outputs the plurality feed light to the respective photoelectric conversion elements 311a, 311b, and 311c. That is, the beam splitter 312 outputs the plurality of feed light 112a, 112b, and 112c in a plurality of wavelength bands obtained through division of the feed light 112W by wavelength, to the plurality of photoelectric conversion elements 311a, 311b, and 311c respectively in a distributed manner. The feed light 112a is input to the photoelectric conversion element 311a. The feed light 112b is input to the photoelectric conversion element 311b. The feed light 112c is input to the photoelectric conversion element 311c.

Fig. 5 illustrates divisional wavelength ranges (assigned the same reference signs as the respective feed light 112a, 112b, and 112c) and conversion wavelength ranges (assigned the same reference signs as the respective photoelectric conversion elements 311a, 311b, and 311c) of the respective photoelectric conversion elements over the spectrum of the wide-band feed light 112W.

The plurality of photoelectric conversion elements 311a, 311b, and 311c respectively correspond to the input plurality of feed light 112a, 112b, and 112c and have the respective conversion wavelength ranges different from each other.

The conversion wavelength range of the photoelectric conversion element 311a is the same as the wavelength range of the feed light 112a. The conversion wavelength range of the photoelectric conversion element 311b is the same as the wavelength range of the feed light 112b. The conversion wavelength range of the photoelectric conversion element 311c is the same as the wavelength range of the feed light 112c.

However, the conversion wavelength range of the photoelectric conversion element (311a) may be slightly wider than the wavelength range of the input feed light (112a) and may overlap the adjacent conversion wavelength range. The conversion wavelength range of any one of the photoelectric conversion elements cannot include the wavelength range of the feed light 112W.

The photoelectric conversion element 311a converts the input feed light 112a into electric power. The photoelectric conversion element 311b converts the input feed light 112b into electric power. The photoelectric conversion element 311c converts the input feed light 112c into electric power.

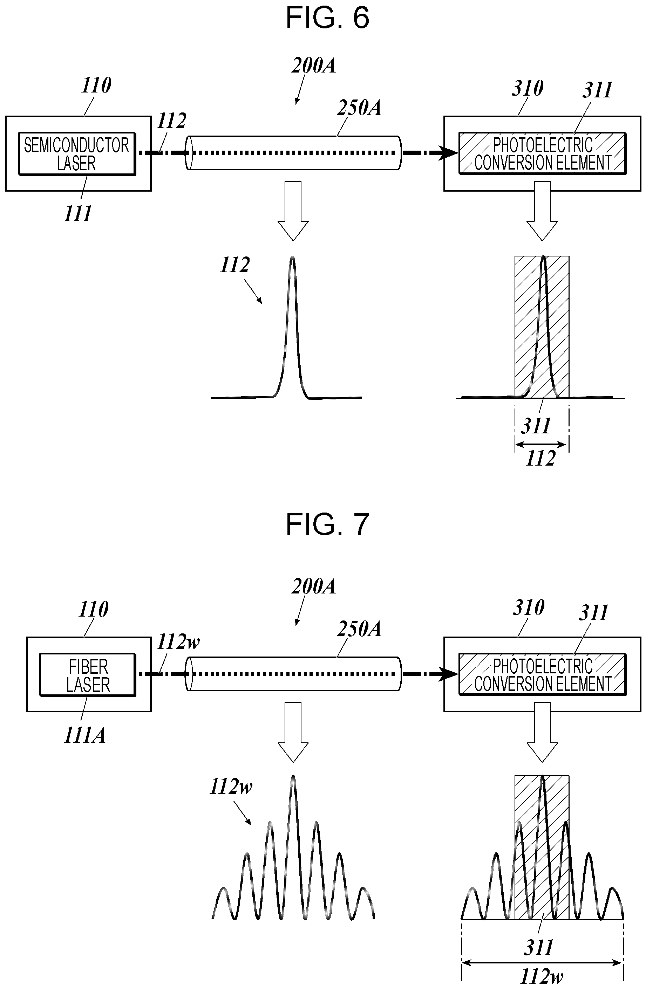

Fig. 6 illustrates a case where the laser light source is the semiconductor laser 111.

In the case of the semiconductor laser 111, a spectrum is narrow. Thus, the wavelength range of the feed light 112 can be dealt with by the conversion wavelength range of the single photoelectric conversion element 311. That is, the feed light 112 output by the semiconductor laser 111 includes almost no light that is out of the conversion wavelength range of the photoelectric conversion element 311.

As illustrated in Fig. 7, only the laser light source is replaced with the fiber laser 111A in such a system illustrated in Fig. 6.

The feed light 112W output by the fiber laser 111A is of a wide band. Thus, light that is out of the conversion wavelength range of the photoelectric conversion element 311 is caused, and this light is not converted into electricity.

Thus, highly efficient photoelectric conversion cannot be performed.

On the other hand, in the power-over-fiber system 1C illustrated in Fig. 5, the beam splitter 312 splits the wide-band feed light 112W output by the fiber laser 111A by wavelength, and the three photoelectric conversion elements 311a, 311b, and 311c perform photoelectric conversion in a distributed manner. Thus, no light that is out of the conversion wavelength ranges of the photoelectric conversion elements 311a, 311b, and 311c is caused as illustrated in Fig. 5, and highly efficient photoelectric conversion can be performed.

Thus, the power-over-fiber system 1C can perform photoelectric conversion on the feed light without the feed light becoming out of the conversion wavelength ranges of the photoelectric conversion elements and thus can maintain a high power supply efficiency. Optical power supply of large electric power can be performed using high-energy feed light of the fiber laser.

While the embodiments of the present disclosure have been described above, these embodiments are merely presented as examples and can be carried out in various other forms. Each component may be omitted, replaced, or modified within a range not departing from the scope of the invention as defined by the appended claims.

In the power-over-fiber system 1C according to the embodiment described above, the powered device 310A includes three photoelectric conversion elements. However, implementation may be carried out using two photoelectric conversion elements or four or more photoelectric conversion elements.

In the power-over-fiber system 1C according to the embodiment described above, the fiber laser is used. However, the implementation is not limited to this, and the present invention can be broadly carried out in the case of a combination in which the wavelength range of the laser used in optical power supply is wider than the conversion wavelength range of a single photoelectric conversion element.

### Industrial Applicability

The present invention can be used for optical power supply.

### Reference Signs List

1A power-over-fiber system
1 power-over-fiber system
1B power-over-fiber system
1C power-over-fiber system
100 first data communication device
110 power sourcing equipment
111 semiconductor laser for power supply
111A fiber laser
112 feed light
120 transmitter
125 signal light
130 receiver
140 light input/output part
141 optical connector
200A optical fiber cable
200 optical fiber cable
200B optical fiber cable
210 core
220 cladding
250A optical fiber
250 optical fiber
260 optical fiber
270 optical fiber
300 second data communication device
310 powered device
311 photoelectric conversion element
311a photoelectric conversion element
311b photoelectric conversion element
311c photoelectric conversion element
312 beam splitter
320 transmitter
325 signal light
330 receiver
350 light input/output part
351 optical connector

## Claims

1. An optical power supply system comprising: power sourcing equipment (110A) including a laser comprising a fiber laser (111A), the laser being configured to oscillate with electric power to output wide-band feed light (112w); and a powered device (310A) configured to receive the feed light (112w),
the powered device (310A) comprising:
a beam splitter (312) configured to
receive the feed light (112w) and
split the feed light (112w) into
a first feed light (112a) having a first wavelength band and
a second feed light (112b) having a second wavelength band different from the first wavelength band;
a first photoelectric conversion element (311a) configured to
receive the first feed light (112a) from the beam splitter (312) and
convert the first feed light (112a) into electric power by photoelectric effect; and
a second photoelectric conversion element (311b) configured to
receive the second light (112b) from the beam splitter (312) and
convert the second light (112b) into electric power by photoelectric effect,
wherein the first photoelectric conversion element (311a) and the second photoelectric conversion element (311b) respectively correspond to the received first feed light (112a) and the received second feed light (112b) and have respective conversion wavelength ranges different from each other.

2. The optical power supply system according to Claim 1, wherein at least one of the first photoelectric conversion element (311a) and the second photoelectric conversion element (311b) comprises a semiconductor material that comprises a semiconductor region that exhibits the photoelectric effect, and the semiconductor material is a laser medium having a laser wavelength of 500 nm or shorter.

3. The optical power supply system according to Claim 1 or 2 comprising: an optical fiber cable (200A) having one end connectable to the power sourcing equipment (110A) and another end connectable to the powered device (310A) and configured to transmit the feed light (112w).

## Patentansprüche

1. Optische-Energieversorgung-System, aufweisend: eine Energieversorgungseinrichtung (110A), die einen Laser aufweist, der einen Faserlaser (111A) aufweist, wobei der Laser konfiguriert ist, um mit elektrischer Energie zu oszillieren, um Breitband-Zuführlicht (112w) auszugeben, und eine energieversorgte Vorrichtung (310A), die konfiguriert ist, um das Zuführlicht (112w) zu empfangen,
wobei die energieversorgte Vorrichtung (310A) aufweist:
einen Strahlteiler (312), der konfiguriert ist, um
das Zuführlicht (112w) zu empfangen und
das Zuführlicht (112w) in
ein erstes Zuführlicht (112a) mit einem ersten Wellenlängenband und
ein zweites Zuführlicht (112b) mit einem zweiten Wellenlängenband, das sich von dem ersten Wellenlängenband unterscheidet, zu teilen,
ein erstes Photoelektrische-Umwandlung-Element (311a), das konfiguriert ist, um
das erste Zuführlicht (112a) von dem Strahlteiler (312) zu empfangen und
das erste Zuführlicht (112a) durch einen photoelektrischen Effekt in elektrische Energie umzuwandeln, und
ein zweites Photoelektrische-Umwandlung-Element (311b), das konfiguriert ist, um
das zweite Licht (112b) von dem Strahlteiler (312) zu empfangen und
das zweite Licht (112b) durch einen photoelektrischen Effekt in elektrische Energie umzuwandeln,
wobei das erste Photoelektrische-Umwandlung-Element (311a) und das zweite Photoelektrische-Umwandlung-Element (311b) mit dem empfangenen ersten Zuführlicht (112a) bzw. dem empfangenen zweiten Zuführlicht (112b) korrespondieren und voneinander verschiedene Umwandlungswellenlängenbereiche aufweisen.

2. Optische-Energieversorgung-System gemäß Anspruch 1, wobei mindestens eines von dem ersten Photoelektrische-Umwandlung-Element (311a) und dem zweiten Photoelektrische-Umwandlung-Element (311b) ein Halbleitermaterial aufweist, das einen Halbleiterbereich aufweist, der den photoelektrischen Effekt zeigt, und das Halbleitermaterial ein Lasermedium mit einer Laserwellenlänge von 500 nm oder kürzer ist.

3. Optische-Energieversorgung-System gemäß Anspruch 1 oder 2, aufweisend: ein optisches Faserkabel (200A), aufweisend ein Ende, das mit der Energieversorgungseinrichtung (110A) verbindbar ist, und ein anderes Ende, das mit der energieversorgten Vorrichtung (310A) verbindbar ist, und das konfiguriert ist, um das Zuführlicht (112w) zu übertragen.

## Revendications

1. Système d'alimentation en énergie optique, comprenant : un équipement d'alimentation en énergie (110A) comprenant un laser comprenant un laser à fibre (111A), le laser étant configuré pour osciller avec de l'énergie électrique afin d'émettre une lumière d'alimentation à large bande (112w) ; et un dispositif alimenté (310A) configuré pour recevoir la lumière d'alimentation (112w),
le dispositif alimenté (310A) comprenant :
un séparateur de faisceau (312) configuré pour
recevoir la lumière d'alimentation (112w) et
diviser la lumière d'alimentation (112w) en
une première lumière d'alimentation (112a) ayant une première bande de longueur d'onde et
une deuxième lumière d'alimentation (112b) ayant une deuxième bande de longueur d'onde différente de la première bande de longueur d'onde ;
un premier élément de conversion photoélectrique (311a) configuré pour
recevoir la première lumière d'alimentation (112a) provenant du séparateur de faisceau (312) et
convertir la première lumière d'alimentation (112a) en énergie électrique par effet photoélectrique ; et
un deuxième élément de conversion photoélectrique (311b) configuré pour
recevoir la deuxième lumière (112b) provenant du séparateur de faisceau (312) et
convertir la deuxième lumière (112b) en énergie électrique par effet photoélectrique,
dans lequel le premier élément de conversion photoélectrique (311a) et le deuxième élément de conversion photoélectrique (311b) correspondent respectivement à la première lumière d'alimentation reçue (112a) et à la deuxième lumière d'alimentation reçue (112b) et ont des plages de longueurs d'onde de conversion respectives différentes l'une de l'autre.

2. Système d'alimentation en énergie optique selon la revendication 1, dans lequel au moins l'un parmi le premier élément de conversion photoélectrique (311a) et le deuxième élément de conversion photoélectrique (311b) comprend un matériau semi-conducteur qui comprend une région semiconductrice qui présente l'effet photoélectrique, et le matériau semi-conducteur est un milieu laser ayant une longueur d'onde laser de 500 nm ou moins.

3. Système d'alimentation en énergie optique selon la revendication 1 ou 2, comprenant : un câble à fibre optique (200A) ayant une extrémité pouvant être connectée à l'équipement d'alimentation en énergie (110A) et une autre extrémité pouvant être connectée au dispositif alimenté (310A) et configuré pour transmettre la lumière d'alimentation (112w).
